# EUROPÄISCHE PATENTSCHRIFT

(11) **EP 1 637 020 B1**
(45) Veröffentlichungstag und Bekanntmachung des Hinweises auf die Patenterteilung: **01.04.2009**
(21) Anmeldenummer: 04736390.8
(22) Anmeldetag: 09.06.2004
(51) Int. Cl.: H05K 7/20

(54) **KÜHLANLAGE FÜR EINEN SCHALTSCHRANK**
COOLING SYSTEM FOR A SWITCHGEAR CABINET
INSTALLATION DE REFROIDISSEMENT POUR ARMOIRE DE DISTRIBUTION

(30) Priorität: 13.06.2003 DE 10326803
(43) Veröffentlichungstag der Anmeldung: 22.03.2006
(73) Patentinhaber: Rittal GmbH & Co. KG, 35745 Herborn (DE)
(72) Erfinder: NICOLAI, Michael, 35466 Rabenau (DE); DÖRRICH, Martin, 35764 Sinn (DE)
(74) Vertreter: Fleck, Hermann-Josef
(86) Internationale Anmeldenummer: PCT/EP2004/006233
(87) Internationale Veröffentlichungsnummer: WO 2004/112452

(56) Entgegenhaltungen:
- DE-A- 2 138 376
- DE-A- 10 112 389
- US-A- 5 718 628

## Beschreibung

Die Erfindung betrifft eine Kühlanlage zur Kühlung eines Schaltschrankes mit im Innenraum desselben übereinander angeordneter, wärmeerzeugender Einbauten, denen individuelle Kühlkörper zugeordnet sind, die über eine Vorlaufleitung und eine Rücklaufleitung in einen Kühlmittelkreislauf einbezogen sind, wobei die Kühlkörper über individuelle Gerätezuleitungen mit der Vorlaufleitung und der Rücklaufleitung verbunden und mit Kühlmittel versorgt sind und wobei der Kühlmittelkreislauf über die Kühlmittel-Ausgangsseite eines Luft-/Wasser-Wärmetauschers geschlossen ist.

Eine derartige Kühlanlage zur Kühlung eines derartig ausgerüsteten Schaltschrankes ist aus der DE 101 12 389 A1 bekannt. Bei dieser Kühlanlage sind die Kühlkörper als plattenförmige Aufnahme-Wärmetauscher ausgebildet und in den Zwischenschlitzen zwischen den Einbauten angeordnet. Der große Luft-/Wasser-Wärmetauscher ist außerhalb des Schaltschrankes angeordnet und muss mit dem als Abgabe-Wärmetauscher mit den Komponenten der Kühlanlage im Schaltschrank-Innenraum verbunden werden. Der Abgabe-Wärmetauscher wird nur von der Umgebungsluft des Schaltschrankes gekühlt und hat daher einen begrenzten Wärmetauscher-Wirkungsgrad. Zudem ist der Aufbau des Schaltschrankes mit der Kühlanlage kompliziert und aufwändig.

Aus der DE 696 17 089 T2 ist eine Anordnung zur Kühlung eines Schaltschrankes mit im Innenraum übereinander angeordneten wärmeerzeugenden Einbauten bekannt. Die Einbauten werden von einem Kühlluftstrom gekühlt, der von einer zentralen Kühlluftanlage erzeugt und einem Hohlraum zwischen dem Doppelboden des Schaltschrank-Aufstellungsraumes zugeführt wird. Dabei wird der Kühlluftstrom über den Boden des Schaltschrankes eingeleitet und strömt über die verbleibenden Luftkanäle zwischen den Einbauten und dem Schaltschrankgehäuse nach oben und kann über Luftauslässe in der Schaltschrankoberseite in den Schaltschrank-Aufstellungsraum austreten. Obwohl die dem Schaltschrank-Innenraum zugeführte Kühlluft kälter gewählt werden kann wie eine Raumluft, lässt die Wirkung der Kühlanlage im Wirkungsgrad zu wünschen übrig. Dies um so mehr als heute kompakte Einbauten mit erheblich höherer Wärmeerzeugung im Schaltschrank-Innenraum in größerer Packungsdichte untergebracht werden.

Es ist Aufgabe der Erfindung, eine Kühlanlage der eingangs erwähnten Art zu schaffen, die gerade für Einbauten mit hoher Wärmeerzeugung bei großer Packungsdichte eine bessere Kühlleistung ermöglicht, ohne den Aufbau des Schaltschrankes und dessen Aufstellung zu erschweren.

Diese Aufgabe wird nach der Erfindung dadurch gelöst, dass der Luft-/Wasser-Wärmetauscher im Bodenbereich des Schaltschrankes angeordnet ist und mit seiner Luft-Eingangsseite über eine Lufteintrittsöffnung des Schaltschrankbodens und eine Luftaustrittsöffnung eines Doppelbodens eines Schaltschrank-Aufstellungsbodens mit einer zentralen Klimatisierungseinrichtung gekoppelt ist, die den Doppelboden mit Kaltluft versorgt und dass in den geschlossenen Kühlmittelkreislauf eine Pumpe und ein Ausdehnungsgefäß einbezogen sind.

Bei dieser Ausgestaltung wird die höhere Kühlleistung der zentralen Klimatisierungseinrichtung ausgenützt, wobei der Schaltschrank mit den Komponenten der Kühlanlage als Baueinheit nur mit dem Kaltluft führenden Doppelboden gekoppelt werden muss, was sehr einfach möglich ist. Zudem wird im Schaltschrank ein geschlossener Kühlmittelkreislauf optimiert, was den Wirkungsgrad steigert und auch bei großer Packungsdichte und bei hoher Wärmeerzeugung der Einbauten Vorteile bringt. Vorzugsweise kann vorgesehen werden, dass die Kühlkörper in die dicht übereinander angeordneten Einbauten integriert sind, oder dass die Einbauten selbst als Kühlkörper ausgebildet sind.

Die Kopplung der Schaltschrank-Baueinheit mit der zentralen Klimatisierungseinrichtung wird dadurch einfach erreicht, dass der Doppelboden mittels Abdeckplatten verschlossene Luftaustrittsöffnungen aufweist, die am Aufstellungsort eines Schaltschrankes mit den eingebauten Komponenten der Kühlanlage entfernbar sind.

Die Kaltluft der zentralen Klimatisierungseinrichtung kann dadurch optimal zur Kühlung der im Schaltschrank-Innenraum untergebrachten Einbauten ausgenützt werden, dass dem Luft-/Wasser-Wärmetauscher ein Lüfter nachgeordnet ist, der die Kaltluft nach dem Durchströmen des Luft-/Wasser-Wärmetauschers dem Innenraum des Schaltschrankes zuführt. Dabei ist vorteilhafter Weise vorgesehen, dass die dem Innenraum des Schaltschrankes zugeführte Kaltluft im oberen Bereich des Schaltschrankes in den Aufstellungsraum des Schaltschrankes gezielt ausleitbar ist, was zur besseren Ausnutzung der Raumklimaanlage führt.

Der geschlossene Kühlmittelkreislauf ist vorzugsweise mit Wasser gefüllt, das dadurch in Strömung gehalten wird, dass die Pumpe und das Ausdehnungsgefäß zwischen Luft-/Wasser-Wärmetauscher und die Vorlaufleitung einbezogen sind.

Vom konstruktiven Aufbau betrachtet, ist eine Ausgestaltung von Vorteil, die dadurch gekennzeichnet ist, dass der Luft-/Wasser-Wärmetauscher, der Lüfter, die Pumpe und das Ausdehnungsgefäß in einem abgeteilten Raum des Schaltschrankes untergebracht sind, da dieser Aufbau der Kühlanlage den Einbau der Einbauten im Schaltschrank-Innenraum kaum beeinträchtigt. Dabei kann dieser Aufbau noch dadurch vereinfacht werden, dass der abgeteilte Raum mit den eingebauten Komponenten als getrennte Baueinheit ausgebildet ist, auf der der Schaltschrank aufbaubar und mit der Vorlaufleitung und der Rücklaufleitung mit den zugeordneten Anschlüssen der Baueinheit verbindbar ist.

Der Platzbedarf für die Vorlaufleitung, die Rücklaufleitung und die individuellen Gerätezuleitungen kann dadurch klein gehalten werden, dass die Vorlaufleitung und die Rücklaufleitung in einem zwischen der Schrankwand und den Einbauten gebildeten vertikalen Kanal über die gesamte Höhe des Schaltschrank-Innenraumes geführt und im oberen Bereich desselben über eine Verbindungsleitung mit Entlüftungsvorrichtung miteinander verbunden sind. Die Führung von der Vorlaufleitung und der Rücklaufleitung kann vom Montageaufwand betrachtet noch dadurch vereinfacht und erleichtert werden, dass bei einem Schaltschrank mit Rahmengestell und Verkleidungselementen die Vorlaufleitung und die Rücklaufleitung in einer Aufnahme oder einem Hohlraum von vertikalen Rahmenschenkeln des Rahmengestelles geführt sind.

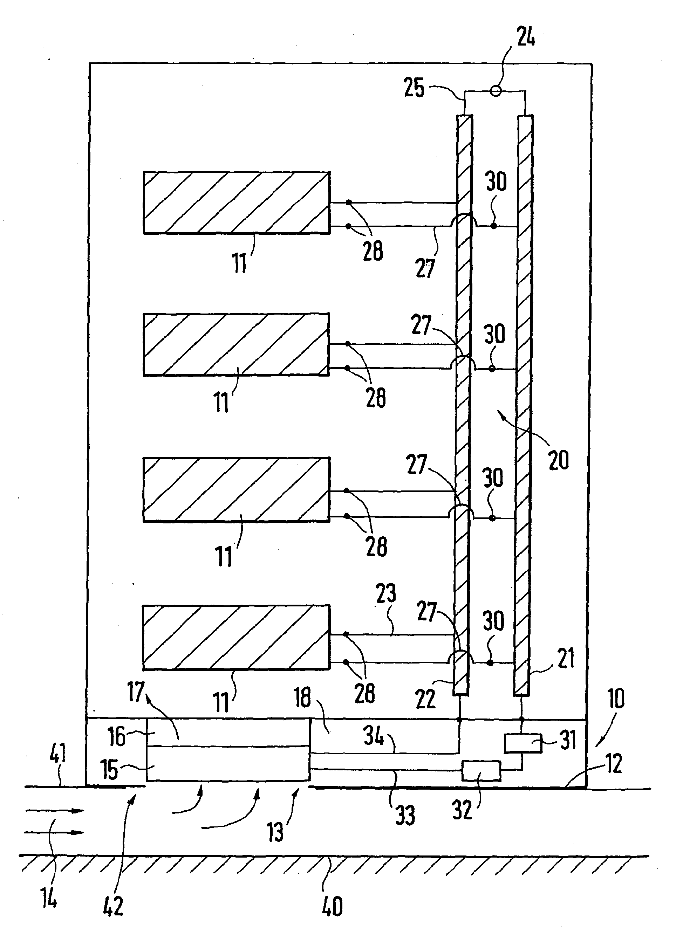

Die Erfindung wird anhand eines in der Zeichnung schematisch dargestellten Ausführungsbeispiels näher erläutert.

In der Zeichnung ist mit den Bezugszeichen 40 und 41 der Doppelboden des Schaltschrank-Aufstellungsraumes gekennzeichnet, dem die Kaltluft 14 der zentralen, nicht dargestellten Klimatisierungseinreichung zugeführt wird. Der Teil 41 des Doppelbodens dient als Aufstellfläche für den Schaltschrank 10. Dabei können Abdeckplatten zur Bildung einer Luftaustrittsöffnung 42 entfernt werden. Im Boden 12 des Schaltschrankes 10 ist eine Lufteintrittsöffnung 13 für die Kaltluft 14 vorgesehen. Der Schaltschrank 10 braucht daher nur mit seiner Lufteintrittsöffnung 13 fluchtend mit der Luftaustrittsöffnung 42 des Bodenteils 41 aufgestellt zu werden.

Die Kaltluft 14 durchströmt nach dem Passieren der Lufteintrittsöffnung 13 den Luft-/Wasser-Wärmetauscher 15 und kühlt das über den Luft-/Wasser-Wärmetauscher 15 fließende Kühlmittel, vorzugsweise Wasser. Der Luft-/Wasser-Wärmetauscher 15 ist mit seiner Kühlmittel-Ausgangsseite in einem geschlossenen und mit Wasser gefüllten Kühlmittelkreislauf 20 einbezogen, der über die Zuleitungen 33 und 34 und die Vorlaufleitung 21 und die Rücklaufleitung 22 und die daran angeschlossenen Kühlkörper 11 geschlossen ist. Dabei sind die übereinander angeordneten Einbauten mit ihren Kühlkörpern 11 über Gerätezuleitungen 23 und 27 mit der Vorlaufleitung 21 und der Rücklaufleitung verbunden. Dabei können die Anschlüsse über lösbare Kupplungen 28 und 30 vorgenommen sein, die einen Verschluss nach dem Lösen übernehmen. In die Vorlaufleitung 21 und die Zuleitung 33 ist eine Pumpe 31 und ein Ausdehnungsgefäß 32 einbezogen, die die Strömung des Kühlmittels Wasser im Kühlmittelkreislauf 20 unabhängig vom Druck und der Temperatur des Kühlmittels aufrecht erhalten. Dabei kann die Vorlaufleitung 21 im oberen Bereich des Schaltschrank-Innenraumes 17 über eine Verbindungsleitung 25 mit Entlüftungsvorrichtung 24 mit der Rücklaufleitung 22 verbunden sein.

Die Kühlkörper 11 sind den Einbauten individuell zugeordnet und können in diese wärmeleitend integriert sein und die Kühlung vornehmen. Die Einbauten können mit ihren Gehäusen selbst als Kühlkörper ausgebildet und vom Kühlmittel durchflossen sein.

Die Kaltluft 14 der zentralen Klimatisierungseinrichtung kann nach dem Passieren des Luft-/Wasser-Wärmetauschers 15 über einen Lüfter 16 dem Innenraum 17 des Schaltschrankes 10 zugeführt werden. Im Innenraum 17 steigt die erwärmte, jedoch immer noch kalte Luft in Kanälen nach oben, die zwischen den Einbauten und dem Schaltschrank verbleiben, und beteiligt sich weiter an der Kühlung der Einbauten. Schließlich kann die aufsteigende Luft über Luftauslässe des Schaltschrankes 10 in die Umgebungsluft des Schaltschrankes 10 ausströmen. Der Luft-/Wasser-Wärmetauscher 15, der Lüfter 16, die Pumpe 31 und das Ausdehnungsgefäß 32 können in einem im Schaltschrank-Innenraum 17 abgeteilten Raum 18 untergebracht sein und beeinträchtigen daher ein Einbau der Einbauten mit ihren Kühlkörpern 11 nicht.

Der Raum 18 kann aber auch durch eine getrennte Baueinheit gebildet werden und diese Komponenten der Kühlanlage aufnehmen. Diese Baueinheit wird in gleicher Weise mit der zentralen Klimatisierungseinrichtung über den Doppelboden 40, 41 gekoppelt. Die Baueinheit kann als Sockel für den Schaltschrank 10 benutzt werden, wobei nur der aufgesetzte Schaltschrank 10 der Vorlaufleitung 21 und der Rücklaufleitung 22 mit dem Luft-/Wasser-Wärmetauscher 15 verbunden werden und der Lüfter 16 mit dem Schaltschrank-Innenraum 17 gekoppelt werden muss. Zudem kann die getrennte Baueinheit mechanisch mit dem Schaltschrank 10 verbunden werden.

## Patentansprüche

1. Kühlanlage zur Kühlung eines Schaltschrankes (10) mit im Innenraum desselben übereinander angeordneter, wärmeerzeugender Einbauten, denen individuelle Kühlkörper (11) zugeordnet sind, die über eine Vorlaufleitung (21) und eine Rücklaufleitung (22) in einen Kühlmittelkreislauf (20) einbezogen sind, wobei die Kühlkörper (11) über individuelle Gerätezuleitungen (30, 23) mit der Vorlaufleitung (21) und der Rücklaufleitung (22) verbunden und mit Kühlmittel versorgt sind und wobei der Kühlmittelkreislauf (20) über die Kühlmittel-Ausgangsseite eines Luft-/Wasser-Wärmetauschers (15) geschlossen ist,
**dadurch gekennzeichnet,**
**dass** der Luft-/Wasser-Wärmetauscher (15) im Bodenbereich (18) des Schaltschrankes (10) angeordnet ist und mit seiner Luft-Eingangsseite über eine Lufteintrittsöffnung (13) des Schaltschrankbodens (12) und eine Luftaustrittsöffnung (42) eines Doppelbodens (40, 41) eines Schaltschrank-Aufstellungsbodens miteiner zentralen Klimatisierungseinrichtung gekoppelt ist, die den Doppelboden (40, 41) mit Kaltluft (14) versorgt und
**dass** in den geschlossenen Kühlmittelkreislauf (20) eine Pumpe (31) und ein Ausdehnungsgefäß (32) einbezogen sind.

2. Kühlanlage nach Anspruch 1,
**dadurch gekennzeichnet,**
**dass** die Kühlkörper (11) in die dicht übereinander angeordneten Einbauten integriert sind.

3. Kühlanlage nach Anspruch 1,
**dadurch gekennzeichnet,**
**dass** die Einbauten selbst als Kühlkörper (11) ausgebildet sind.

4. Kühlanlage nach einem der Ansprüche 1 bis 3,
**dadurch gekennzeichnet,**
**dass** der Doppelboden (40, 41) mittels Abdeckplatten verschlossene Luftaustrittsöffnungen (42) aufweist, die am Aufstellungsort eines Schaltschrankes (10) mit den eingebauten Komponenten der Kühlanlage entfernbar sind.

5. Kühlanlage nach einem der Ansprüche 1 bis 4,
**dadurch gekennzeichnet,**
**dass** dem Luft-/Wasser-Wärmetauscher (15) ein Lüfter (16) nachgeordnet ist, der die Kaltluft (14) nach dem Durchströmen des Luft-/Wasser-Wärmetauschers (15) dem Innenraum (17) des Schaltschrankes (10) zuführt.

6. Kühlanlage nach Anspruch 5,
**dadurch gekennzeichnet,**
**dass** die dem Innenraum (17) des Schaltschrankes (10) zugeführte Kaltluft (14) im oberen oder hinteren Bereich des Schaltschrankes (10) in den Aufstellungsraum des Schaltschrankes (10) ausleitbar ist.

7. Kühlanlage nach einem der Ansprüche 1 bis 6,
**dadurch gekennzeichnet,**
**dass** die Pumpe (31) und das Ausdehnungsgefäß (32) zwischen Luft-/Wasser-Wärmetauscher (15) und die Vorlaufleitung (21) einbezogen sind.

8. Kühlanlage nach einem der Ansprüche 1 bis 7,
**dadurch gekennzeichnet,**
**dass** der Luft-/Wasser-Wärmetauscher (15), der Lüfter (16), die Pumpe (31) und das Ausdehnungsgefäß (32) in einem abgeteilten Raum (18) des Schaltschrankes (10) untergebracht sind.

9. Kühlanlage nach Anspruch 8,
**dadurch gekennzeichnet,**
**dass** der abgeteilte Raum (18) mit den eingebauten Komponenten als getrennte Baueinheit ausgebildet ist, auf der der Schaltschrank (10) aufbaubar und mit der Vorlaufleitung (21) und der Rücklaufleitung (22) mit den zugeordneten Anschlüssen der Baueinheit verbindbar ist.

10. Kühlanlage nach einem der Ansprüche 1 bis 9,
**dadurch gekennzeichnet,**
**dass** die Vorlaufleitung (21) und die Rücklaufleitung (22) in einem zwischen der Schrankwand und den Einbauten gebildeten vertikalen Kanal über die gesamte Höhe des Schaltschrank-Innenraumes (17) geführt und im oberen Bereich desselben über eine Verbindungsleitung (25) mit Entlüftungsvorrichtung (24) miteinander verbunden sind.

11. Kühlanlage nach einem der Ansprüche 1 bis 10,
**dadurch gekennzeichnet,**
**dass** bei einem Schaltschrank (10) mit Rahmengestell und Verkleidungselementen die Vorlaufleitung (21) und die Rücklaufleitung (22) in einer Aufnahme oder einem Hohlraum von vertikalen Rahmenschenkeln des Rahmengestelles geführt sind.

## Claims

1. Cooling system for cooling a switchgear cabinet (10) having heat-generating fittings which are arranged one above the other in the inner space of the latter and which are assigned individual cooling bodies (11) which are incorporated into a coolant circuit (20) via a forward-flow line (21) and a return-flow line (22), the cooling bodies (11) being connected to the forward-flow line (21) and to the return-flow line (22) via individual appliance supply lines (30, 23) and being supplied with coolant, and the coolant circuit (20) being closed via the coolant outlet side of an air/water heat exchanger (15), **characterized in that** the air/water heat exchanger (15) is arranged in the bottom region (18) of the switchgear cabinet (10) and is coupled with its air inlet side, via an air inflow port (13) of the switchgear cabinet bottom (12) and via an air outflow port (42) of a double floor (40, 41) of a switchgear cabinet installation base, to a central air-conditioning arrangement which supplies the double floor (40, 41) with cold air (14), and **in that** a pump (31) and an expansion vessel (32) are incorporated into the closed coolant circuit (20).

2. Cooling system according to Claim 1, **characterized in that** the cooling bodies (11) are integrated into the fittings arranged closely one above the other.

3. Cooling system according to Claim 1, **characterized in that** the fittings themselves are designed as cooling bodies (11).

4. Cooling system according to one of Claims 1 to 3, **characterized in that** the double floor (40, 41) has air outflow ports (42) which are closed by means of cover plates and which can be removed at the place of installation of a switchgear cabinet (10) having the fitted components of the cooling system.

5. Cooling system according to one of Claims 1 to 4, **characterized in that** the air/water heat exchanger (15) is followed by a fan (16) which supplies the cold air (14), after it flows through the air/water heat exchanger (15), to the inner space (17) of the switchgear cabinet (10).

6. Cooling system according to Claim 5, **characterized in that** the cold air (14) supplied to the inner space (17) of the switchgear cabinet (10) can be discharged into the installation space of the switchgear cabinet (10) in the upper or rear region of the latter.

7. Cooling system according to one of Claims 1 to 6, **characterized in that** the pump (31) and the expansion vessel (32) are incorporated between the air/water heat exchanger (15) and the forward-flow line (21).

8. Cooling system according to one of Claims 1 to 7, **characterized in that** the air/water heat exchanger (15), the fan (16), the pump (31) and the expansion vessel (32) are accommodated in a partitioned-off space (18) of the switchgear cabinet (10).

9. Cooling system according to Claim 8, **characterized in that** the partitioned-off space (18) having the fitted components is designed as a separate structural unit, on which the switchgear cabinet (10) can be built and can be connected to the assigned connections of the structural unit by means of the forward-flow line (21) and the return-flow line (22).

10. Cooling system according to one of Claims 1 to 9, **characterized in that** the forward-flow line (21) and the return-flow line (22) are routed, in a vertical duct formed between the cabinet wall and the fittings, over the entire height of the switchgear cabinet inner space (17) and are connected to one another in the upper region of the latter via a connecting line (25) having a venting device (24).

11. Cooling system according to one of Claims 1 to 10, **characterized in that**, in the case of a switchgear cabinet (10) with a frame rack and with cladding elements, the forward-flow line (21) and the return-flow line (22) are routed in a receptacle or a cavity of vertical frame legs of the frame rack.

## Revendications

1. Équipement de refroidissement pour refroidir une armoire électrique (10) à l'intérieur de laquelle se trouvent des composants installés calorifiques disposés les uns au-dessus des autres auxquels sont associés des dissipateurs thermiques (11) individuels, lesquels sont intégrés dans un circuit de fluide de refroidissement (20) par le biais d'une conduite aller (21) et d'une conduite de retour (22), les dissipateurs thermiques (11) étant reliés par le biais de conduites d'arrivée d'appareil (30, 23) individuelles avec la conduite aller (21) et la conduite de retour (22) et étant alimentés en fluide de refroidissement et le circuit de refroidissement (20) étant fermé par le côté sortie du fluide de refroidissement d'un échangeur thermique air/eau (15), **caractérisé en ce que** l'échangeur thermique air/eau (15) est disposé dans la zone du fond (18) de l'armoire électrique (10) et son côté entrée d'air est connecté par le biais d'une ouverture d'entrée d'air (13) du fond de l'armoire électrique (12) et une ouverture de sortie d'air (42) d'un double fond (40, 41) d'un fond d'installation de l'armoire électrique à un équipement de climatisation central qui alimente le double fond (40, 41) en air frais (14) et qu'une pompe (31) ainsi qu'un vase d'expansion (32) sont intégrés dans le circuit de refroidissement fermé (20).

2. Équipement de refroidissement selon la revendication 1, **caractérisé en ce que** les dissipateurs thermiques (11) sont intégrés dans les composants installés disposés très proches les uns au-dessus des autres.

3. Équipement de refroidissement selon la revendication 1, **caractérisé en ce que** les composants installés sont eux-mêmes réalisés sous la forme de dissipateurs thermiques (11).

4. Équipement de refroidissement selon l'une des revendications 1 à 3, **caractérisé en ce que** le double fond (40, 41) présente des ouvertures de sortie d'air (42) fermées au moyen de plaques de recouvrement qui peuvent être retirées sur le lieu d'installation d'une armoire électrique (10) avec les composants intégrés de l'équipement de refroidissement.

5. Équipement de refroidissement selon l'une des revendications 1 à 4, **caractérisé en ce que** l'échangeur thermique air/eau (15) est suivi par un ventilateur (16) qui achemine l'air frais (14) dans l'espace intérieur (17) de l'armoire électrique (10) après qu'il ait traversé l'échangeur thermique air/eau (15).

6. Équipement de refroidissement selon la revendication 5, **caractérisé en ce que** l'air frais (14) acheminé dans l'espace intérieur (17) de l'armoire électrique (10) peut être évacué dans le local d'installation de l'armoire électrique (10) dans la zone supérieure ou arrière de l'armoire électrique (10).

7. Équipement de refroidissement selon l'une des revendications 1 à 6, **caractérisé en ce que** la pompe (31) et le vase d'expansion (32) sont intégrés entre l'échangeur thermique air/eau (15) et la conduite aller (21).

8. Équipement de refroidissement selon l'une des revendications 1 à 7, **caractérisé en ce que** l'échangeur thermique air/eau (15), le ventilateur (16), la pompe (31) et le vase d'expansion (32) sont logés dans un espace compartimenté (18) de l'armoire électrique (10).

9. Équipement de refroidissement selon la revendication 8, **caractérisé en ce que** l'espace compartimenté (18) avec les composants intégrés est réalisé sous la forme d'un sous-ensemble séparé, sur lequel peut être monté l'armoire électrique (10) qui peut être relié à la conduite aller (21) et la conduite de retour (22) avec les raccords associés du sous-ensemble.

10. Équipement de refroidissement selon l'une des revendications 1 à 9, **caractérisé en ce que** la conduite aller (21) et la conduite de retour (22) passent dans un conduit vertical formé entre la paroi de l'armoire et les composants installés sur toute la hauteur de l'espace intérieur de l'armoire électrique (17) et sont reliées entre elles dans la zone supérieure de celui-ci par le biais d'une conduite de liaison (25) munie d'un dispositif de purge (24).

11. Équipement de refroidissement selon l'une des revendications 1 à 10, **caractérisé en ce que** dans le cas d'une armoire électrique (10) avec baie et éléments d'habillage, la conduite aller (21) et la conduite de retour (22) passent dans un logement ou dans un espace creux des branches verticales du châssis de la baie.
